# EUROPEAN PATENT APPLICATION

(11) **EP 4 827 262 A1**
(43) Date of publication of application: **21.10.2026**
(21) Application number: 26162686.5
(22) Date of filing: 05.03.2026
(51) Int. Cl.: H10B 43/27, H10B 41/27, H10B 41/40, H10B 43/40, H10B 80/00

(54) **THREE-DIMENSIONAL SEMICONDUCTOR MEMORY DEVICE WITH OVERLAPPING CONTACTS, AND ELECTRONIC SYSTEM INCLUDING THE SAME**

(30) Priority: 14.04.2025 KR 20250048154; 30.06.2025 KR 20250086741
(71) Applicant: Samsung Electronics Co., Ltd., Suwon-si, Gyeonggi-do 16677 (KR)
(72) Inventor: KIM, Hakseon, 16677 Suwon-si (KR); PARK, Sejun, 16677 Suwon-si (KR); LEE, Sea Hoon, 16677 Suwon-si (KR); CHANG, Seongpil, 16677 Suwon-si (KR)
(74) Representative: Marks & Clerk LLP

(57) **Abstract**

A three-dimensional semiconductor memory device includes a first peripheral circuit structure (PS1) and a second peripheral circuit structure (PS2) sequentially provided on a first substrate (10). The second peripheral circuit structure includes a second substrate (100) having a first surface (100a) and a second surface (100b) facing the first surface, a transistor array (TA) including transistors (TR2) on the first surface of the second substrate, an insulating layer (40) on the second surface of the second substrate, a conductive line (CL) extending in the insulating layer in a first direction parallel to the first surface of the second substrate, and a conductive contact (CT) between the conductive line and the second surface of the second substrate.

## Description

### BACKGROUND

The present disclosure herein relates to a three-dimensional semiconductor memory device and an electronic system including the same.

Semiconductor memory devices capable of storing high-volume data are required for electronic systems that require data storage. It is required to increase integration density of a semiconductor device to satisfy the requirements of a low price and excellent performance that consumers require while increasing data storage capacity. The integration density of a two-dimensional or planar semiconductor device is mostly determined by the area occupied by a unit memory cell, and is thus significantly affected by the level of a micropattern forming technology. However, the integration density of a semiconductor device is increasing but is still limited since high-priced equipment is required for micropatterning. Therefore, three-dimensional semiconductor devices having three-dimensionally arranged memory cells are proposed.

### SUMMARY

The present disclosure provides a three-dimensional semiconductor memory device having improved electrical characteristics and an electronic system including the same.

The present disclosure also provides a three-dimensional semiconductor memory device having improved integration density and an electronic system including the same.

The problems to be solved by this disclosure are not limited to the above-mentioned problems, and other problems not mentioned would be clearly understood by those of ordinary skill in the art from the disclosure below.

Some implementations of this disclosure provides a three-dimensional semiconductor memory device including a first peripheral circuit structure and a second peripheral circuit structure sequentially provided on a first substrate, wherein the second peripheral circuit structure includes: a second substrate having a first surface and a second surface facing the first surface; a transistor array including transistors on the first surface of the second substrate; an insulating layer on the second surface of the second substrate; a conductive line extending in the insulating layer in a direction parallel to the first surface of the second substrate; and a conductive contact between the conductive line and the second surface of the second substrate.

In some implementations of this disclosure, a three-dimensional semiconductor memory device includes a first peripheral circuit structure, a second peripheral circuit structure, and a cell array structure sequentially provided on a first substrate, wherein the second peripheral circuit structure includes: a second substrate; a transistor array including transistors on the second substrate and interposed between the second substrate and the cell array structure; an insulating layer between the second substrate and the first peripheral circuit structure; a conductive line extending in the insulating layer in a direction parallel to a first surface of the second substrate; and a conductive contact between the conductive line and the second substrate.

In some implementations of this disclosure, an electronic system includes: a three-dimensional semiconductor memory device; and a controller electrically connected to the three-dimensional semiconductor memory device through an input/output pad and configured to control the three-dimensional semiconductor memory device, wherein the three-dimensional semiconductor memory device includes a first peripheral circuit structure and a second peripheral circuit structure sequentially provided on a first substrate, wherein the second peripheral circuit structure includes: a second substrate having a first surface and a second surface facing the first surface; a transistor array including transistors on the first surface of the second substrate; an insulating layer on the second surface of the second substrate; a conductive line extending in the insulating layer in a direction parallel to the first surface of the second substrate; and a conductive contact between the conductive line and the second surface of the second substrate.

In some implementations of this disclosure, a method for manufacturing a three-dimensional semiconductor memory device includes: forming a first peripheral circuit structure on a first substrate; forming a first circuit structure including a transistor array including transistors on a first surface of a second substrate; forming a second circuit structure including a conductive contact on a second surface, facing the first surface, of the second substrate, a conductive line on the conductive contact, and an insulating layer covering the conductive contact and the conductive line after flipping the second substrate; and bonding the second circuit structure onto the first peripheral circuit structure.

In some implementations, the method may include forming a contact region in the second substrate by performing an impurity injection process to inject an impurity into the second surface of the second substrate before forming the second circuit structure.

In some implementations, forming the transistors may include forming gate structures on the first surface of the second substrate and source/drain regions by performing a first impurity injection process to inject a first impurity into the second substrate, and may include forming a contact region in the second substrate by performing a second impurity injection process to inject a second impurity into the second surface of the second substrate before forming the second circuit structure, wherein the first impurity injected through the first impurity injection process is different from the second impurity injected through the second impurity injection process.

In some implementations, the conductive contact may be formed in contact with the second surface of the second substrate.

In some implementations, the conductive contact may be formed so as to vertically overlap the transistor array.

In some implementations, the forming of the first peripheral circuit structure may include forming peripheral transistors on the first substrate, first contacts and first circuit lines connected to the peripheral transistors, a peripheral insulating layer covering the peripheral transistors, the first contacts, and the first circuit lines, and a first bonding layer on the peripheral insulating layer, and the forming of the second circuit structure may include forming a second bonding layer on the insulating layer, wherein the bonding process may include bringing the second bonding layer into contact with the first bonding layer.

In some implementations, the forming of the first peripheral circuit structure may include forming peripheral transistors on the first substrate and first contacts and first circuit lines connected to the peripheral transistors, and, after the first bonding process, may include: forming a first penetration pattern extending into the second substrate and connected to the conductive line; and forming a second penetration pattern extending into the second substrate and connected to one of the first circuit lines.

In some implementations, a height of the first penetration pattern may be less than a height of the second penetration pattern.

In some implementations, the method may include performing a second bonding process to bond a cell array structure onto the first circuit structure after the first bonding process.

In some implementations, the first circuit structure may include first bonding pads, the cell array structure may include second bonding pads, and the second bonding process may include bringing the second bonding pads into contact with the first bonding pads.

At least some of the above and other features of the invention are set out in the claims.

### BRIEF DESCRIPTION OF THE FIGURES

The accompanying drawings are included to provide a further understanding of this disclosure, and are incorporated in and constitute a part of this specification. The drawings illustrate implementations of this disclosure and, together with the description, serve to explain principles of this disclosure. In the drawings:
FIG. 1 is a diagram schematically illustrating an electronic system including a three-dimensional semiconductor memory device according to some implementations of this disclosure;
FIG. 2 is a perspective view schematically illustrating an electronic system including a three-dimensional semiconductor memory device according to some implementations of this disclosure;
FIGS. 3 and 4 are cross-sectional views, taken along line I-I' and line II-II' of FIG. 2, for describing semiconductor packages including a three-dimensional semiconductor memory device according to some implementations of this disclosure;
FIG. 5 is a perspective view schematically illustrating a three-dimensional semiconductor memory device according to some implementations of this disclosure;
FIG. 6 is a plan view illustrating a three-dimensional semiconductor memory device according to some implementations of this disclosure;
FIG. 7 is a cross-sectional view taken along line A-A' of FIG. 6;
FIG. 8 is a cross-sectional view of a cell array structure taken along line A-A' of FIG. 6;
FIG. 9 is a cross-sectional view taken along line A-A' of FIG. 6;
FIG. 10 is a plan view illustrating a three-dimensional semiconductor memory device according to some implementations of this disclosure;
FIG. 11 is a cross-sectional view taken along line A-A' of FIG. 10;
FIG. 12 is a plan view illustrating a three-dimensional semiconductor memory device according to some implementations of this disclosure;
FIG. 13 is a cross-sectional view taken along line A-A' of FIG. 12;
FIGS. 14 to 17 are plan views illustrating a three-dimensional semiconductor memory device according to some implementations of this disclosure; and
FIGS. 18 to 21 are diagrams illustrating a method for manufacturing a three-dimensional semiconductor memory device according to some implementations of this disclosure.

### DETAILED DESCRIPTION

Hereinafter, a three-dimensional semiconductor memory device and a method for manufacturing the same according to implementations of this disclosure will be described with reference to the accompanying drawings.

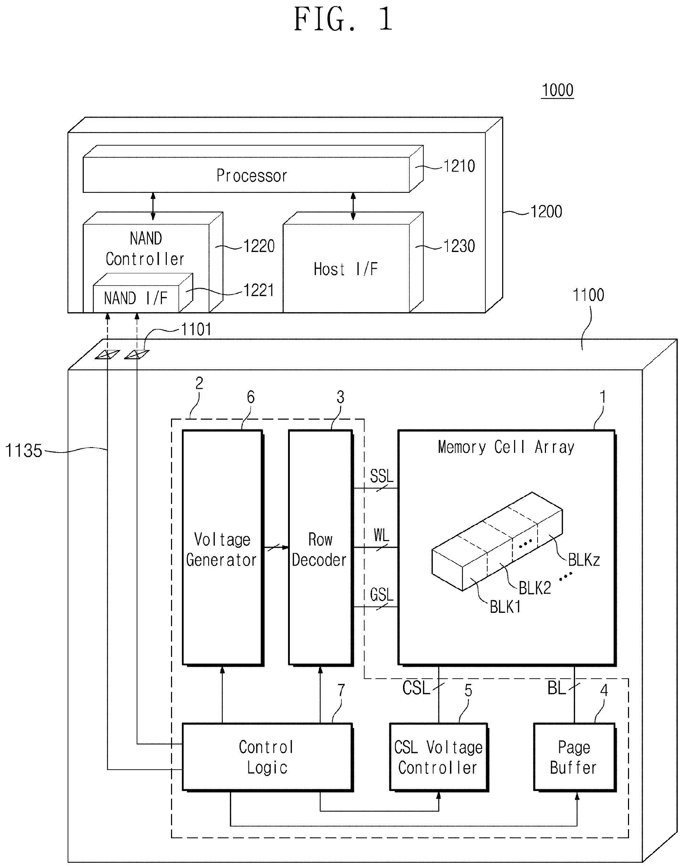

FIG. 1 is a diagram schematically illustrating an electronic system including a three-dimensional semiconductor memory device according to some implementations of this disclosure.

Referring to FIG. 1, an electronic system 1000 according to some implementations of this disclosure may include a three-dimensional semiconductor memory device 1100 and a controller 1200 electrically connected to the three-dimensional semiconductor memory device 1100. The electronic system 1000 may be a storage device including one or more three-dimensional semiconductor memory devices 1100 or an electronic device including the storage device. For example, the electronic system 1000 may be a solid state drive (SSD) device, a universal serial bus (USB), a computing system, a medical device, or a communication device including one or more three-dimensional semiconductor memory devices 1100 or an electronic device including the storage device.

The three-dimensional semiconductor memory device 1100 may be a non-volatile memory device such as a NAND flash memory device.

The three-dimensional semiconductor memory device 1100 may include a memory cell array 1 and a peripheral circuit 2 for controlling the memory cell array 1. The peripheral circuit 2 may include a row decoder 3, a page buffer 4, a common source line (CSL) voltage control circuit 5, a voltage generator 6, and control logic 7.

The memory cell array 1 may include a plurality of memory blocks BLK1 to BLKz. The memory blocks BLK1 to BLKz may each include three-dimensionally arranged memory cells. For example, the memory blocks BLK1 to BLKz may each include stacked structures. The memory blocks BLK1 to BLKz may read or write data from/to a selected memory block in response to a corresponding block selection signal. An erase operation may be performed on the memory cells of the memory cell array 1 on a per-memory block basis.

For example, the three-dimensional semiconductor memory device 1100 may be a vertical NAND flash memory device. In the case of a vertical NAND flash memory device, the memory blocks BLK1 to BLKz may include a plurality of NAND-type cell strings.

The row decoder 3 may select at least one of the plurality of memory blocks BLK1 to BLKz by decoding an externally input address, and may select word lines WL, a string selection line SSL, and a ground selection line GSL of a selected memory block. The row decoder 3 may transfer a voltage for performing a memory operation to the word line WL of the selected memory block.

The page buffer 4 is connected to the cell array 1 through bit lines BL and may read information stored in the memory cells.

The page buffer 4 may operate as a write driver to apply a voltage to the bit line BL, a voltage according to data to be stored in the memory cell array 1 during a program operation, and may operate as a sense amplifier to sense data stored in the memory cell array 1 during a read operation. The page buffer 4 may operate according to a control signal provided from the control logic 7.

The CSL voltage control circuit 5 may be connected to the memory cell array 1 through a common source line CSL. The CSL voltage control circuit 5 may apply a common source voltage (e.g., power supply voltage or ground voltage) to the common source line CSL on the basis of control by the control logic 7.

The voltage generator 6 may generate voltages (e.g., program voltage, read voltage, erase voltage, pass voltage, verification voltage, etc.) required for an internal operation of the memory cell array 1 according to control by the control logic 7.

The control logic 7 may generate various control signals for programming data to the memory cell array 1, reading data from the memory cell array 1, or erasing data stored in the memory cell array 1 on the basis of a command signal, an address signal, and a control signal.

The three-dimensional semiconductor memory device 1100 may communicate with the controller 1200 through an input/output pad 1101 electrically connected to the control logic 7. The input/output pad 1101 may be electrically connected to the control logic 7 through an input/output connection line 1135.

The controller 1200 may include a processor 1210, a NAND controller 1220, and a host interface 1230. According to implementations, the electronic system 1000 may include a plurality of three-dimensional semiconductor memory devices 1100, and, in this case, the controller 1200 may control the plurality of three dimensional semiconductor memory devices 1100.

The processor 1210 may control overall operation of the electronic system 1000 including the controller 1200. The processor 1210 may operate according to predetermined firmware, and may access the three-dimensional memory device 1100 by controlling the NAND controller 1220. The NAND controller 1220 may include a NAND interface 1221 that processes communication with the three-dimensional semiconductor memory device 1100. A control command for controlling the three-dimensional semiconductor memory device 1100, data to be written to the memory cells of the three-dimensional semiconductor memory device 1100, data to be read from the memory cells of the three-dimensional semiconductor memory device 1100, etc. may be transmitted through the NAND interface 1221. The host interface 1230 may provide a function of communication between the electronic system 1000 and an external host. Upon receiving a control command from the external host through the host interface 1230, the processor 1210 may control the three-dimensional semiconductor memory device 1100 in response to the control command.

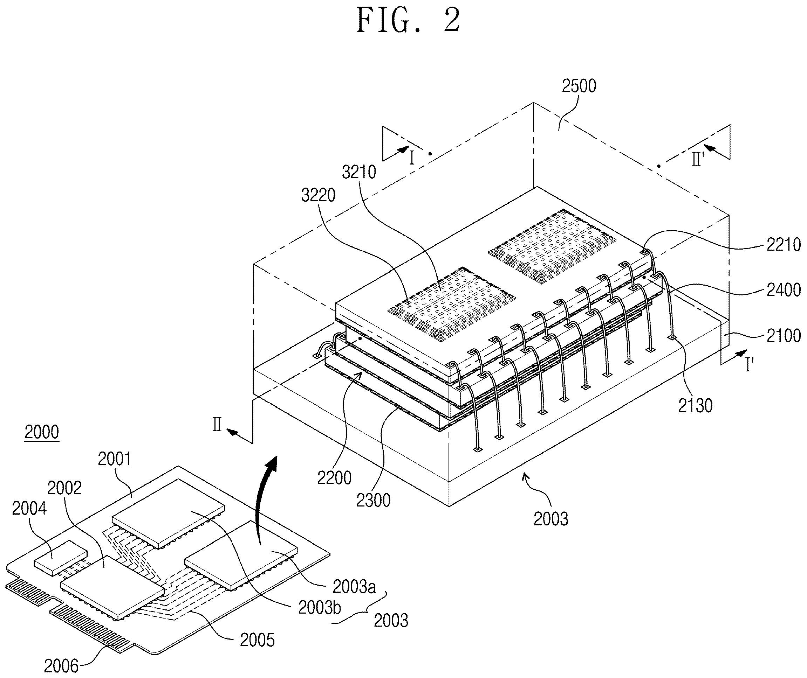

FIG. 2 is a perspective view schematically illustrating an electronic system including a three-dimensional semiconductor memory device according to some implementations of this disclosure.

Referring to FIG. 2, an electronic system 2000 according to some implementations of this disclosure may include a main substrate 2001 and a controller 2002, at least one semiconductor package 2003, and a DRAM 2004, which are mounted on the main substrate 2001. The semiconductor package 2003 and the DRAM 2004 may be connected to the controller 2002 by wiring patterns 2005 formed on the main substrate 2001.

The main substrate 2001 may include a connector 2006 with a plurality of pins connected to an external host. The number and arrangement of the plurality of pins of the connector 2006 may be changed according to a communication interface between the electronic system 2000 and the external host. For example, the electronic system 2000 may communicate with an external host according to any one of interfaces such as Universal Serial Bus (USB), Peripheral Component Interconnect Express (PCI-Express), Serial Advanced Technology Attachment (SATA), and M-PHY for Universal Flash Storage (UFS). For example, the electronic system 2000 may be operated using power supplied from an external host via the connector 2006. The electronic system 2000 may further include a power management integrated circuit (PMIC) for distributing power supplied from an external host to the controller 2002 and the semiconductor package 2003.

The controller 2002 may write data to the semiconductor package 2003 or read data from the semiconductor package 2003, and may improve an operation speed of the electronic system 2000.

The DRAM 2004 may be a buffer memory for reducing a speed difference between an external host and the semiconductor package 2003 that is a data storage space. The DRAM 2004 included in the electronic system 2000 may operate as a type of a cache memory, and may provide a space for temporarily storing data during an operation of controlling the semiconductor package 2003. In the case where the DRAM 2004 is included in the electronic system 2000, the controller 2002 may further include a DRAM controller for controlling the DRAM 2004 in addition to a NAND controller for controlling the semiconductor package 2003.

The semiconductor package 2003 may include first and second semiconductor packages 2003a and 2003b spaced apart from each other. Each of the first and second semiconductor packages 2003a and 2003b may be a semiconductor package including a plurality of semiconductor chips 2200. The first and second semiconductor packages 2003a and 2003b may each include a package substrate 2100, semiconductor chips 2200 on the package substrate 2100, adhesive layers 2300 respectively arranged on lower surfaces of the semiconductor chips 2200, a connection structure 2400 for electrically connecting the semiconductor chips 2200 to the package substrate 2100, and a molding layer 2500 covering the semiconductor chips 2200 and the connection structure 2400 on the package substrate 2100.

The package substrate 2100 may be a printed circuit board including upper pads 2130. Each of the semiconductor chips 2200 may include an input/output pad 2210. Each of the semiconductor chips 2200 may include stack structures 3210 and vertical structures 3220. Each of the semiconductor chips 2200 may include the three-dimensional semiconductor memory device according to implementations of this disclosure described below.

For example, the connection structure 2400 may be a bonding wire for electrically connecting the input/output pad 2210 to the upper pads 2130. Therefore, in each of the first and second semiconductor packages 2003a and 2003b, the semiconductor chips 2200 may be electrically connected to each other through bonding wires and electrically connected to the upper pads 2130 of the package substrate 2100. For example, in each of the first and second semiconductor packages 2003a and 2003b, the semiconductor chips 2200 may be electrically connected to each other by a connection structure including a through-silicon via (TSV) instead of the connection structure 2400 using bonding wires.

For example, the controller 2002 and the semiconductor chips 2200 may be included in a single package. For example, the controller 2002 and the semiconductor chips 2200 may be mounted on a separate interposer substrate different from the main substrate 2001, and may be connected to each other through lines formed on the interposer substrate.

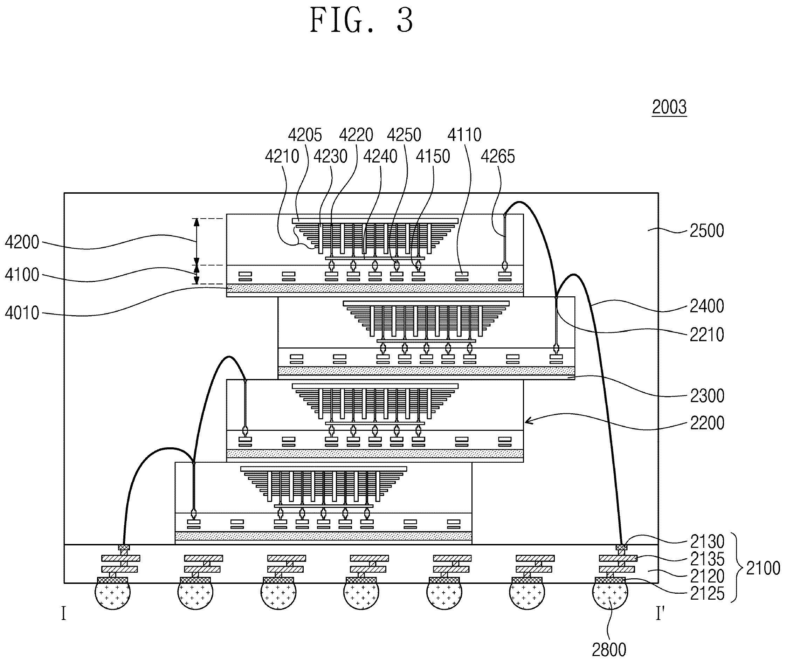

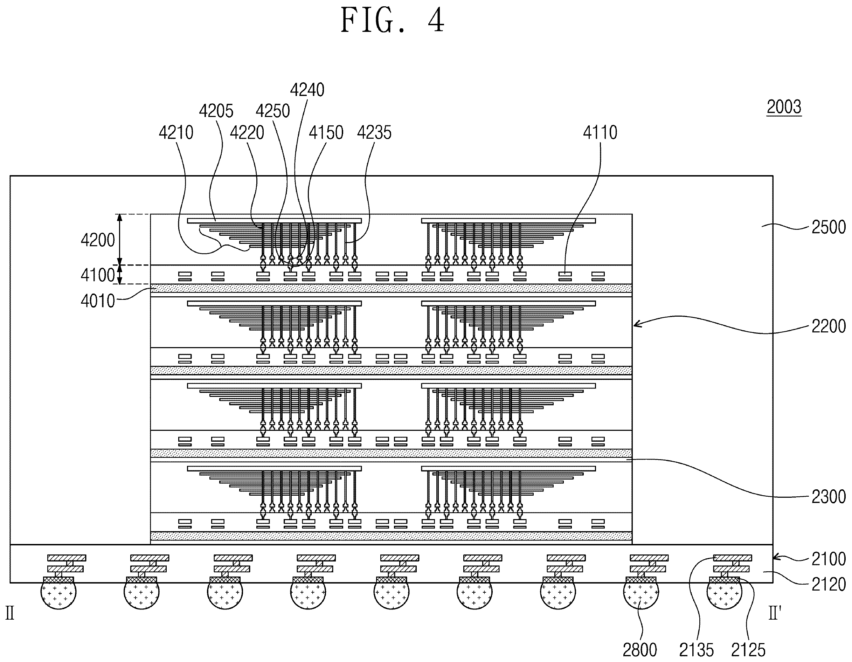

FIGS. 3 and 4 are cross-sectional views, taken along line I-I' and line II-II' of FIG. 2, for describing a semiconductor package including a semiconductor device according to some implementations of this disclosure.

Referring to FIGS. 3 and 4, the semiconductor package 2003 may include the package substrate 2100, the plurality of semiconductor chips 2200 on the package substrate 2100, and the molding layer 2500 covering the package substrate 2100 and the semiconductor chips 2200.

The package substrate 2100 may include a package substrate body part 2120, upper pads 2130 disposed on an upper surface of the package substrate body part 2120 or exposed through the upper surface, lower pads 2125 exposed on a lower surface of the package substrate body part 2120 or exposed through the lower surface, and inner lines 2135, which electrically connect the upper pads 2130 to the lower pads 2125 in the package substrate body part 2120. The upper pads 2130 may be electrically connected to the connection structures 2400. The lower pads 2125 may be connected to the wiring patterns 2005 of the main substrate 2001 of the electronic system 2000 illustrated in FIG. 2 through conductive connection parts 2800.

Referring to FIG. 3, the semiconductor chips 2200 may be connected to each other through the bonding wire-type connection structures 2400. The semiconductor chips 2200 may include substantially the same components.

Referring back to FIGS. 3 and 4, the semiconductor chips 2200 may each include a semiconductor substrate 4010, a first structure 4100 on the semiconductor substrate 4010, and a second structure 4200 on the first structure 4100. The second structure 4200 may be coupled to the first structure 4100 using a wafer bonding method.

The first structure 4100 may include peripheral circuit lines 4110 and first bonding pads 4150. The second structure 4200 may include a common source line 4205, a gate stack structure 4210 between the common source line 4205 and the first structure 4100, memory channel structures 4220 and isolation structures 4230 extending into the gate stack structure 4210, and second bonding pads 4250 respectively and electrically connected to the word lines WL (FIG. 1) of the gate stack structure 4210 and the memory channel structures 4220. For example, the second bonding pads 4250 may be respectively and electrically connected to the memory channel structures 4220 and the word lines WL (FIG. 1) through bit lines 4240 electrically connected to the memory channel structures 4220 and gate connection lines 4235 electrically connected to the word lines WL (FIG. 1). The first bonding pads 4150 of the first structure 4100 and the second bonding pads 4250 of the second structure 4200 may be coupled in contact with each other. Coupled portions of the first bonding pads 4150 and the second bonding pads 4250 may include copper (Cu), for example.

The semiconductor chips 2200 may each further include the input/output pad 2210 and an input/output connection line 4265 under the input/output pad 2210. The input/output connection line 4265 may be electrically connected to some of the second bonding pads 4250 and some of the peripheral circuit lines 4110.

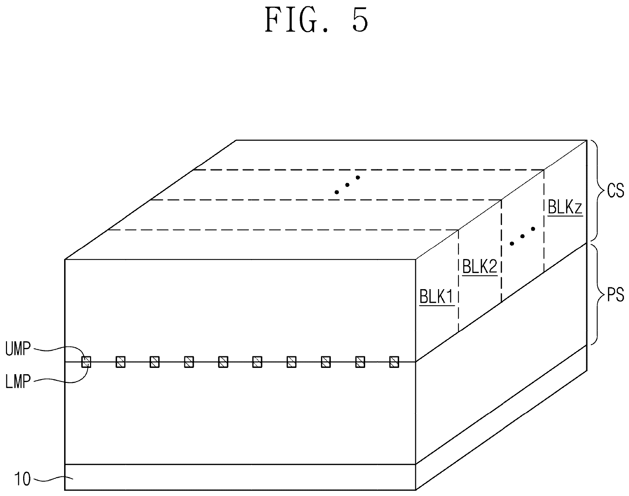

FIG. 5 is a perspective view schematically illustrating a three-dimensional semiconductor memory device according to some implementations of this disclosure.

Referring to FIG. 5, the three-dimensional semiconductor memory device may include a substrate 10, a peripheral circuit structure PS on the substrate 10, and a cell array structure CS on the peripheral circuit structure PS.

The substrate 10 may be the semiconductor substrate 4010 described with reference to FIGS. 3 and 4. The peripheral circuit structure PS may be the first structure 4100 described with reference to FIGS. 3 and 4. The cell array structure CS may be the second structure 4200 described with reference to FIGS. 3 and 4.

The peripheral circuit structure PS may include the peripheral circuit 2 described with reference to FIG. 1. The cell array structure CS may include the plurality of memory blocks BLK1 to BLKz described with reference to FIG. 1.

Lower metal pads LMP may be provided at an upper portion of the peripheral circuit structure PS. The lower metal pads LMP may be the first bonding pads 4150 described with reference to FIGS. 3 and 4. The lower metal pads LMP may be electrically connected to the peripheral circuit 2 of the peripheral circuit structure PS.

Upper metal pads UMP may be provided at a lower portion of the cell array structure CS. The upper metal pads UMP may be the second bonding pads 4250 described with reference to FIGS. 3 and 4. The upper metal pads UMP may be electrically connected to the memory blocks BLK1 to BLKz in the cell array structure CS.

For example, the peripheral circuit structure PS and the cell array structure CS on the substrate 10 may be separately formed. Thereafter, the peripheral circuit structure PS and the cell array structure CS may be connected to each other using a bonding method. In detail, the lower metal pads LMP in the peripheral circuit structure PS may be respectively brought into contact with the upper metal pads UMP in the cell array structure CS through the bonding method, and, accordingly, the peripheral circuit structure PS may be electrically connected to the cell array structure CS.

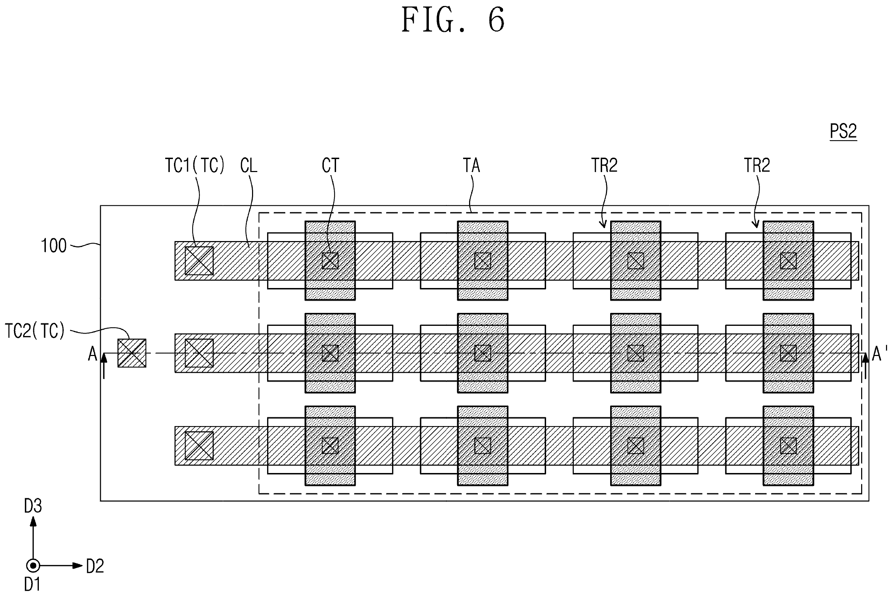

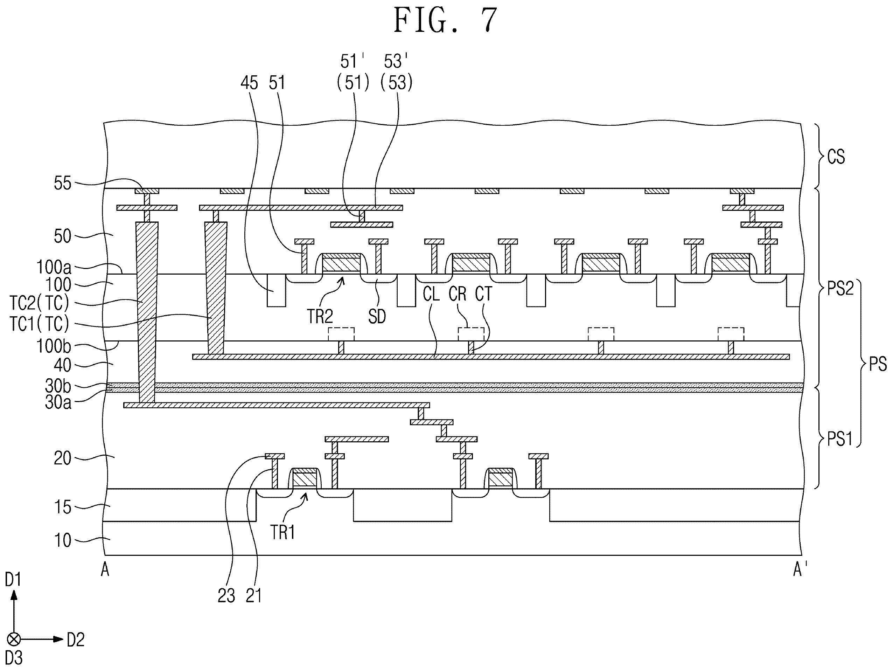

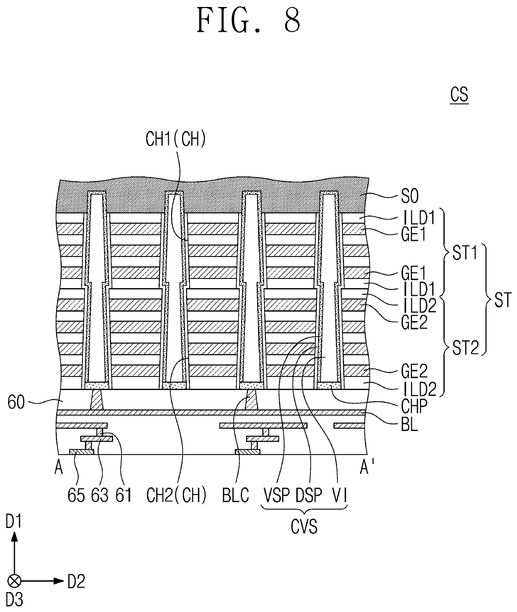

FIG. 6 is a plan view illustrating a three-dimensional semiconductor memory device according to some implementations of this disclosure. FIG. 7 is a cross-sectional view taken along line A-A' of FIG. 6. FIG. 8 is a cross-sectional view of a cell array structure taken along line A-A' of FIG. 6.

Referring to FIGS. 6 and 7, the three-dimensional semiconductor memory device may include a peripheral circuit structure PS on a first substrate 10 and a cell array structure CS on the peripheral circuit structure PS. The first substrate 10 may correspond to the semiconductor substrate 4010 of FIGS. 3 and 4. The peripheral circuit structure PS may correspond to the first structure 4100 of FIGS. 3 and 4. The cell array structure CS may correspond to the second structure 4200 of FIGS. 3 and 4.

According to this disclosure, cell capacity per unit area of the three-dimensional semiconductor memory device according to this disclosure may be increased by coupling the cell array structure CS onto the peripheral circuit structure PS. The peripheral circuit structure PS and the cell array structure CS may be individually manufactured and coupled to each other through a separate process. Accordingly, transistors that will be described later may be prevented from being damaged due to various heat treatment processes. As a result, electrical characteristics and reliability of the three-dimensional semiconductor memory device according to this disclosure may be improved.

The first substrate 10 may be, for example, a monocrystalline epitaxial layer grown on a silicon substrate, silicon-germanium substrate, germanium substrate, or monocrystalline silicon substrate. An upper surface of the first substrate 10 may be orthogonal to a first direction D1. The upper surface of the first substrate 10 may be parallel to a second direction D2 and a third direction D3 intersecting each other. For example, the first to third directions D1 to D3 may be directions orthogonal to each other. A first device isolation layer 15 may be provided in the first substrate 10. The first isolation layer 15 may define an active region of the first substrate 10.

The peripheral circuit structure PS may include a first peripheral circuit structure PS1 and a second peripheral circuit structure PS2, which are sequentially provided on the first substrate 10 in the first direction D1. The first peripheral circuit structure PS1 may include a portion of the peripheral circuit 2 of FIG. 1, and the second peripheral circuit structure PS2 may include another portion of the peripheral circuit 2 of FIG. 1. In other words, the components of the peripheral circuit 2 of FIG. 1 (e.g., the row decoder 3, the page buffer 4, the CSL voltage control circuit 5, the voltage generator 6, the control logic 7, etc.) may be distributively provided to the first peripheral circuit structure PS1 and the second peripheral circuit structure PS2. Accordingly, integration density of the three-dimensional semiconductor memory device may be improved.

For example, the second peripheral circuit structure PS2 may include the row decoder 3 of the peripheral circuit 2, but is not limited thereto.

The first peripheral circuit structure PS1 may include first transistors TR1 on the first substrate 10, first contacts 21, first circuit lines 23 electrically connected to the first transistors TR1 through the first contacts 21, a first insulating layer 20 covering the foregoing, and a first bonding layer 30a on the first insulating layer 20.

For example, the first transistors TR1 may constitute at least one of the row decoder 3, the page buffer 4, the CSL voltage control circuit 5, the voltage generator 6, or the control logic 7 of FIG. 1. For example, the first transistors TR1 may be an NMOS transistor or a PMOS transistor.

For example, the first bonding layer 30a may include an insulating material. For example, the first bonding layer 30a may include SiCN. The first bonding layer 30a may be in contact with a second bonding layer 30b described below so that the first peripheral circuit structure PS1 and the second peripheral circuit structure PS2 may be bonded to each other.

The second peripheral circuit structure PS2 may include a second substrate 100, a second device isolation layer 45 defining an active region of the second substrate 100 in the second substrate 100, a transistor array TA on the second substrate 100, second contacts 51, second circuit lines 53 electrically connected to the transistor array TA through the second contacts 51, first bonding pads 55, and a second insulating layer 50 covering the foregoing.

The second substrate 100 may be, for example, a monocrystalline epitaxial layer grown on a silicon substrate, silicon-germanium substrate, germanium substrate, or monocrystalline silicon substrate.

The second substrate 100 may have a first surface 100a and a second surface 100b. For example, the first surface 100a of the second substrate 100 may be an upper surface of the second substrate 100 as illustrated in the drawings. For example, the second surface 100b of the second substrate 100 may be a lower surface of the second substrate 100 as illustrated in the drawings. For example, the first surface 100a of the second substrate 100 may face the cell array structure CS, and the second surface 100b of the second substrate 100 may face the first peripheral circuit structure PS1.

The transistor array TA may be provided on the first surface 100a of the second substrate 100. The transistor array TA may be interposed between the cell array structure CS and the first surface 100a of the second substrate 100. The transistor array TA may include a plurality of second transistors TR2 two-dimensionally arranged on the first surface 100a in the second direction D2 and the third direction D3. Arrangement of the second transistors TR2 in the transistor array TA may be variously modified by those of ordinary skill in the art.

For example, the second transistors TR2 may constitute at least one of the row decoder 3, the page buffer 4, the CSL voltage control circuit 5, the voltage generator 6, or the control logic 7 of FIG. 1. For example, the second transistors TR2 may constitute the row decoder 3 of FIG. 1. For example, the second transistors TR2 may be an NMOS transistor or a PMOS transistor.

The second transistors TR2 may each include a gate structure and source/drain regions SD in an active region of the second substrate 100. The source/drain regions SD may be provided at an upper portion of the second substrate 100. The source/drain regions SD may include P-type or N-type conductive impurities. The gate structure may include a gate electrode, a gate insulating pattern between the gate electrode and the active region, a gate capping pattern on the gate electrode, and a gate spacer on a side surface of the gate electrode. For example, the gate electrode may include a conductive material. For example, the gate insulating pattern, the gate capping pattern, and the gate spacer may include an insulating material.

The first transistor TR1 may include a gate insulating pattern like the second transistor TR2. For example, a thickness of the gate insulating pattern of the second transistor TR2 may be larger than a thickness of the gate insulating pattern of the first transistor TR1. For example, accordingly, a voltage for driving the second transistor TR2 may be higher than a voltage for driving the first transistor TR1.

The second peripheral circuit structure PS2 may further include a third insulating layer 40 on the second surface 100b of the second substrate 100, a conductive line CL in the third insulating layer 40, a conductive contact CT between the conductive line CL and the second surface 100b of the second substrate 100, and a second bonding layer 30b between the third insulating layer 40 and the first bonding layer 30a.

The third insulating layer 40 may be interposed between the second surface 100b of the second substrate 100 and the first peripheral circuit structure PS1. The third insulating layer 40 may be interposed between the second surface 100b of the second substrate 100 and the second bonding layer 30b.

The conductive line CL may extend in the third insulating layer 40 in the second direction D2. The conductive line CL may extend under the second transistors TR2 of the transistor array TA in the second direction D2. The conductive line CL may vertically overlap the second transistors TR2 of the transistor array TA. For example, the conductive line CL may include a conductive material.

In detail, the conductive line CL may include a plurality of conductive lines CL extending in the second direction D2 and arranged spaced apart from each other in the third direction D3. For example, the conductive lines CL may each extend in the second direction D2 under the second transistors TR2 arranged spaced apart from each other in the second direction D2, and may vertically overlap the second transistors TR2.

The conductive contact CT may be interposed between the second surface 100b of the second substrate 100 and the conductive line CL. The conductive contact CT may be in contact with each of the second surface 100b of the second substrate 100 and the conductive line CL. Accordingly, the second substrate 100 may be connected to the conductive line CL through the conductive contact CT.

The conductive contact CT may be provided under the transistor array TA and vertically overlap the transistor array TA. The conductive contact CT may include a plurality of conductive contacts CT (e.g., a plurality of sub-contacts) arranged spaced apart from each other in the second direction D2 on the conductive line CL. The conductive contacts CT may each vertically overlap the corresponding second transistor TR2 among the second transistors TR2.

The second substrate 100 may include a contact region CR provided at a lower portion of the second substrate 100. The contact region CR may include P-type or N-type conductive impurities. The contract region CR may include impurities of a conductive type different than the impurities of the source/drain region SD of the second transistor TR2. For example, when the second transistor TR2 is an NMOS transistor, the source/drain region SD of the second transistor TR2 may include N-type conductive impurities, and the contact region CR may include P-type conductive impurities. For another example, when the second transistor TR2 is a PMOS transistor, the source/drain region SD of the second transistor TR2 may include P-type conductive impurities, and the contact region CR may include N-type conductive impurities. The contact region CR may include a plurality of contact regions CR. The contact regions CR may vertically overlap the second transistors TR2.

The conductive contact CT may be interposed between the conductive line CL and the contact region CR. The conductive contact CT may vertically overlap the contact region CR. The conductive contact CT may be in contact with the contact region CR.

The conductive contact CT may not extend into the second substrate 100. An upper surface of the conductive contact CT may be located between the first surface 100a and the second surface 100b of the second substrate 100 or may be located at substantially the same level as the second surface 100b. For example, a width of the conductive contact CT in the second direction D2 or the third direction D3 may decrease in the first direction D1.

The second peripheral circuit structure PS2 may further include a penetration pattern TC extending into the second substrate 100 in the first direction D1. The penetration pattern TC may include a first penetration pattern TC1 and a second penetration pattern TC2. The first penetration pattern TC1 and the second penetration pattern TC2 may each include a conductive material.

The first penetration pattern TC1 may extend from the inside of the second insulating layer 50 to the inside of the third insulating layer 40 and may be connected to the conductive line CL. The first penetration pattern TC1 may be connected to each of a portion 51' of the second contacts 51 provided in the second insulating layer 50 and a portion 53' of the second circuit lines 53. Accordingly, the conductive contact CT, the conductive line CL, the first penetration pattern TC1, the portion 51' of the second contacts 51, and the portion 53' of the second circuit lines 53 may constitute a well bias circuit together.

A well bias voltage may be applied to the above-mentioned well bias circuit. The well bias voltage may be delivered to the second substrate 100 through the well bias circuit. In other words, the well bias voltage may be delivered to a well of the transistor array TA including the second transistors TR2 through the well bias circuit. Accordingly, an operation of the second transistors TR2 may be controlled through the well bias voltage.

According to this disclosure, the conductive contacts CT that deliver the well bias voltage to the transistor array TA may be provided on the second surface 100b of the second substrate 100. Since some components (e.g., the conductive contacts CT and conductive lines CL) constituting the well bias circuit are provided on the second surface 100b of the second substrate 100, the integration density of the three-dimensional semiconductor memory device may be improved. Furthermore, a degree of freedom of design of the second circuit lines 53 and the second contacts 51 provided on the second surface 100b of the second substrate 100 may be improved.

As a comparative example, when the conductive contacts CT that deliver the well bias voltage are provided on the first surface 100a of the second substrate 100 and outside the transistor array TA, a distance between the conductive contacts CT and the second transistors TR2 at a center of the transistor array TA may increase. In this case, electrical resistance between the conductive contacts CT and the second transistors TR2 provided at the center of the transistor array TA may increase, and electrical characteristics of the three-dimensional semiconductor memory device may deteriorate.

On the contrary, according to this disclosure, since the conductive contacts CT that deliver the well bias voltage to the transistor array TA are provided on the second surface 100b of the second substrate 100, the conductive contacts CT may vertically overlap the second transistors TR2. In other words, in a plan view, the conductive contacts CT may be provided in the transistor array TA. Accordingly, the distance between the conductive contacts CT and the second transistors TR2 provided at the center of the transistor array TA may be smaller than the distance between the conductive contacts CT and the second transistors TR2 provided at the center of the transistor array TA of the above-mentioned comparative example. As a result, the electrical resistance between the conductive contacts CT and the second transistors TR2 provided at the center of the transistor array TA may decrease. Therefore, the electrical characteristics of the three-dimensional semiconductor memory device may be improved.

In addition, due to the above-mentioned features of this disclosure, the distance between the conductive contacts CT and the second transistors TR2 provided at the center of the transistor array TA may be substantially the same as the distance between the conductive contacts CT and the second transistors TR2 provided at a periphery of the transistor array TA. Accordingly, a difference in the bias voltage delivered to the second transistors TR2 in the transistor array TA may be reduced. As a result, a dispersion of operating characteristics of the second transistors TR2 controlled through the well bias voltage may be reduced. Therefore, the electrical characteristics of the three-dimensional semiconductor memory device may be improved.

The first penetration pattern TC1 may include first penetration patterns TC1 arranged spaced apart from each other in the third direction D3. The first penetration patterns TC1 may each be connected to the corresponding conductive line CL among the conductive lines CL.

The second penetration pattern TC2 may extend from the inside of the second insulating layer 50 to the inside of the first insulating layer 20 and may be connected to the first circuit line 23 in the first insulating layer 20. The second penetration pattern TC2 is illustrated as a single pattern but is not limited thereto and may be provided in plurality. For example, a height of the first penetration pattern TC1 may be less than a height of the second penetration pattern TC2.

The second bonding layer 30b may be in contact with the first bonding layer 30a. Accordingly, the first peripheral circuit structure PS1 and the second peripheral circuit structure PS2 may be bonded to each other. For example, the second bonding layer 30b may include an insulating material. For example, the second bonding layer 30b may include the same material as the first bonding layer 30a. For example, the second bonding layer 30b may include SiCN.

The first bonding pads 55 may be provided at an upper portion of the second insulating layer 50. The first bonding pads 55 may be in contact with second bonding pads 65 in the cell array structure CS described below. Accordingly, the cell array structure CS and the peripheral circuit structure PS may be bonded and electrically connected to each other through the first bonding pads 55. In detail, the first transistors TR1 may be electrically connected to the cell array structure CS through the first bonding pad 55, the second contact 51, the second circuit line 53, the second penetration pattern TC2, the first contact 21, and the first circuit line 23. The second transistors TR2 may be electrically connected to the cell array structure CS through the first bonding pad 55, the second contact 51, and the second circuit line 53. The first bonding pads 55 may correspond to the first bonding pads 4150 of FIGS. 3 and 4.

For example, the first bonding pads 55 and the second bonding pads 65 may each include Cu.

Referring to FIGS. 6, 7, and 8, the cell array structure CS may be provided on the peripheral circuit structure PS. In detail, the cell array structure CS may be provided on the second peripheral circuit structure PS2. The cell array structure CS may include the second bonding pads 65, third contacts 61, third circuit lines 63, bit lines BL, bit lines contacts BLC, a fourth insulating layer 60 covering the foregoing, a stack structure ST on the fourth insulating layer 60, cell vertical structures CVS extending into the stack structure ST, and a source layer SO on the stack structure ST. The bit lines BL may correspond to the bit lines 4240 of FIGS. 3 and 4. The stack structure ST may correspond to the gate stack structure 4210 of FIGS. 3 and 4. The second bonding pads 65 may correspond to the second bonding pads 4250 of FIGS. 3 and 4.

The bit lines BL may extend in the second direction D2 and may be spaced apart from each other in the third direction D3. The bit lines BL may each be connected to the cell vertical structure CVS through the bit line contact BLC.

The stack structure ST may include a first stack structure ST1 on the fourth insulating layer 60 and a second stack structure ST2 between the first stack structure ST1 and the fourth insulating layer 60. The first stack structure ST1 may include first interlayer insulating layers ILD1 and first gate electrodes GE1 that are alternately stacked, and the second stack structure ST2 may include second interlayer insulating layers ILD2 and second gate electrodes GE2 that are alternately stacked.

At least one of the first gate electrodes GE1 may be the ground selection lines GSL (FIG. 1). The ground selection line GSL may control a ground selection transistor. For example, the ground selection line GSL (FIG. 1) may be located at an upper portion of the stack structure ST.

At least one of the second gate electrodes GE2 may be the string selection lines SSL (FIG. 1). The string selection line SSL (FIG. 1) may control a string selection transistor. For example, the string selection line SSL (FIG. 1) may be located at a lower portion of the stack structure ST.

Channel holes CH may extend into the stack structure ST in the first direction D1. The channel hole CH may include a first channel hole CH1 extending into the first stack structure ST1 and a second channel hole CH2 extending into the second stack structure ST2. For example, widths of each of the first and second channel holes CH1 and CH2 in the second direction D2 and/or third direction D3 may decrease in the first direction D1. The first and second channel holes CH1 and CH2 may be connected to each other. A diameter of the second channel hole CH2 may be less than a diameter of the first channel hole CH1 at a boundary of connection therebetween. The first and second channel holes CH1 and CH2 may have a step at the boundary of connection therebetween. However, some implementations of this disclosure are not limited thereto, and, for example, three or more channel holes having steps at two or more boundaries may be provided. For another example, channel holes having flat sidewalls without a step may be provided.

The cell vertical structures CVS may be provided in the channel holes CH. The cell vertical structure CVS may extend in the first direction D1 and extend into the stack structure ST. The cell vertical structure CVS may include a data storage patten DSP and a semiconductor pattern VSP sequentially covering a sidewall of the channel hole CH, a channel pad CHP between the semiconductor pattern VSP and the bit line contact BLC, and an inner insulating layer VI filling a remainder of the channel hole CH.

The data storage pattern DSP and the semiconductor pattern VSP may each extend into at least a portion of the stack structure ST and extend in the first direction D1. The data storage pattern DSP may extend in the first direction D1 between the stack structure ST and the semiconductor pattern VSP.

For example, the semiconductor pattern VSP may include a semiconductor material doped with impurities, an intrinsic semiconductor material undoped with impurities, or a polycrystalline semiconductor material.

The semiconductor pattern VSP may be in contact with the channel pad CHP, and the channel pad CHP may be in contact with the bit line contact BLC. Accordingly, the bit line BL may be connected to the semiconductor pattern VSP through the bit line contact BLC and the channel pad CHP.

The data storage pattern DSP may include a blocking insulating layer, a charge storage layer, and a tunneling insulating layer that are sequentially provided on an inner sidewall of the channel hole CH.

The data storage pattern DSP may store and/or modify data due to a Fowler-Nordheim tunneling phenomenon induced by a voltage difference between the semiconductor pattern VSP and the first and second gate electrodes GE1 and GE2. For example, the blocking insulating layer and the tunneling insulating layer may include silicon oxide, and the charge storage layer may include at least one of silicon nitride or silicon oxynitride.

The source layer SO may be provided on the stack structure ST. The source layer SO may include a conductive material. For example, the source layer SO may include at least one of undoped polysilicon or doped polysilicon. The source layer SO may correspond to the common source line 4205 described with reference to FIGS. 3 and 4.

The semiconductor pattern VSP may extend into at least a portion of the stack structure ST and extend into the source layer SO. Since a portion of the semiconductor pattern VSP is inserted into the source layer SO, the source layer SO and the semiconductor pattern VSP may be connected to each other.

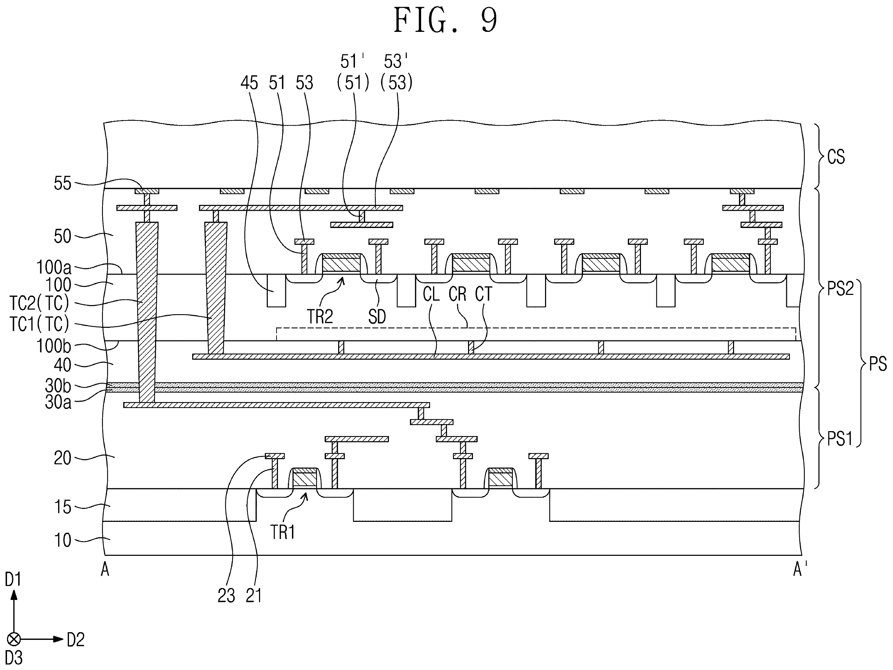

Hereinafter, a three-dimensional semiconductor memory device according to other implementations of this disclosure will be described with reference to FIGS. 9 to 17. For conciseness, descriptions overlapping with the above descriptions will be omitted, and differences will be mainly described.

FIG. 9 is a cross-sectional view taken along line A-A' of FIG. 6.

Referring to FIGS. 6 and 9, a formation location and range of the contact region CR may be variously modified by those of ordinary skill in the art.

For example, the contact region CR may be formed over a lower portion of the second substrate 100 overlapping the transistor array TA, unlike the contact regions CR locally formed within the second substrate 100, described with reference to FIG. 7. Accordingly, the conductive contacts CT arranged spaced apart from each other in the second direction D2 may share a single contact region CR.

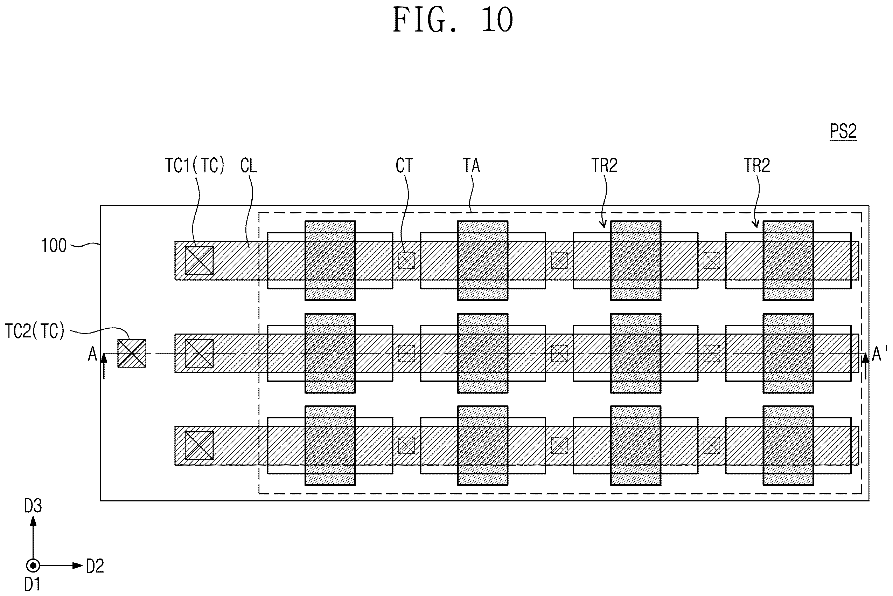

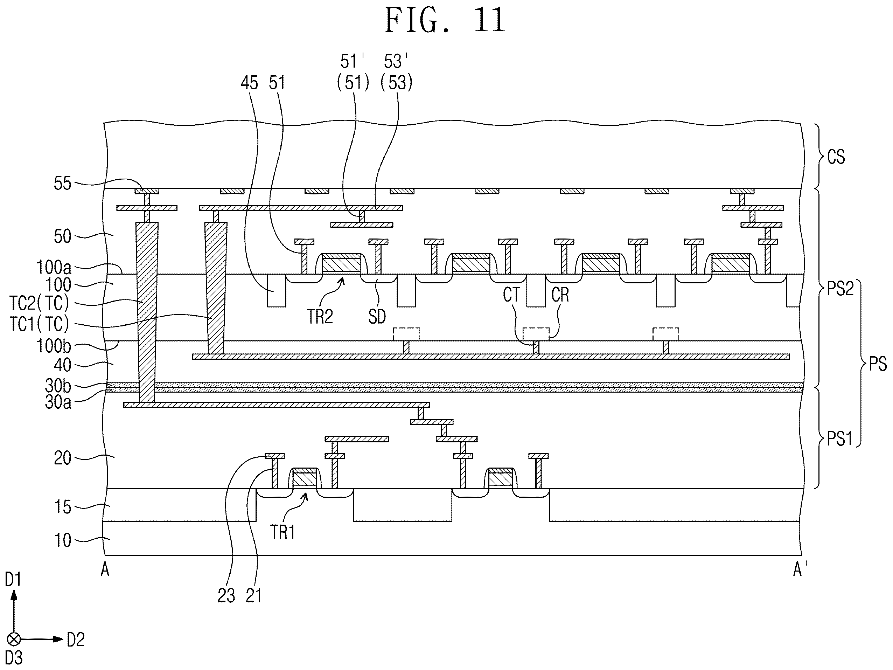

FIG. 10 is a plan view illustrating a three-dimensional semiconductor memory device according to some implementations of this disclosure. FIG. 11 is a cross-sectional view taken along line A-A' of FIG. 10.

Referring to FIGS. 10 and 11, a formation location of the conductive contact CT and a formation location of the contact region CR may be variously modified by those of ordinary skill in the art without being limited to the above descriptions provided with reference to FIGS. 6 and 7.

As described above with reference to FIGS. 6 and 7, the conductive contact CT and the contact region CR may each vertically overlap the transistor array TA. In a plan view, the conductive contact CT may be interposed between the second transistors TR2 arranged spaced apart from each other in the second direction D2 unlike the above descriptions provided with reference to FIGS. 6 and 7. Accordingly, operation characteristics of the plurality of second transistors TR2 may be controlled by providing the well bias voltage to the plurality of second transistors TR2 through a single conductive contact CT.

In a plan view, the contact region CR may be interposed between the second transistors TR2 arranged spaced apart from each other in the second direction D2 according to the above-mentioned formation location of the conductive contact CT.

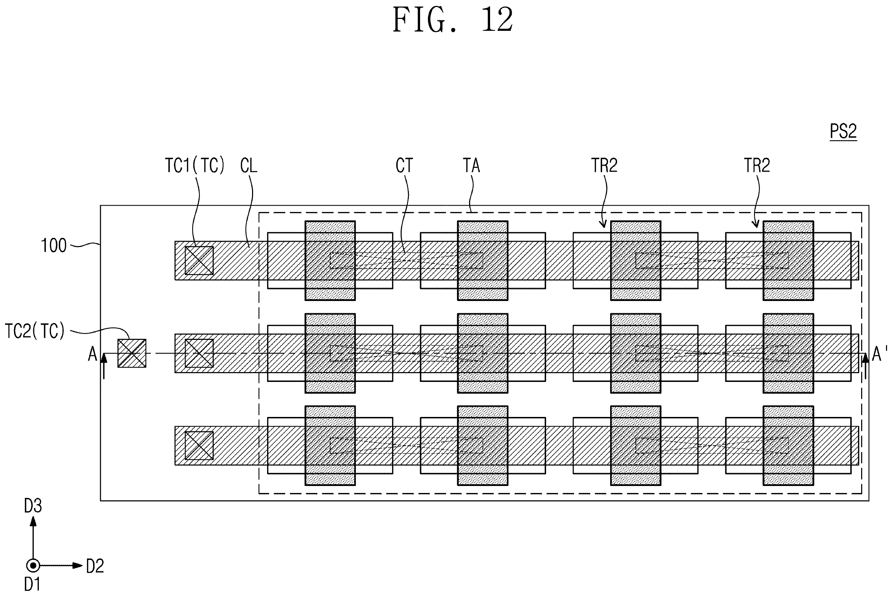

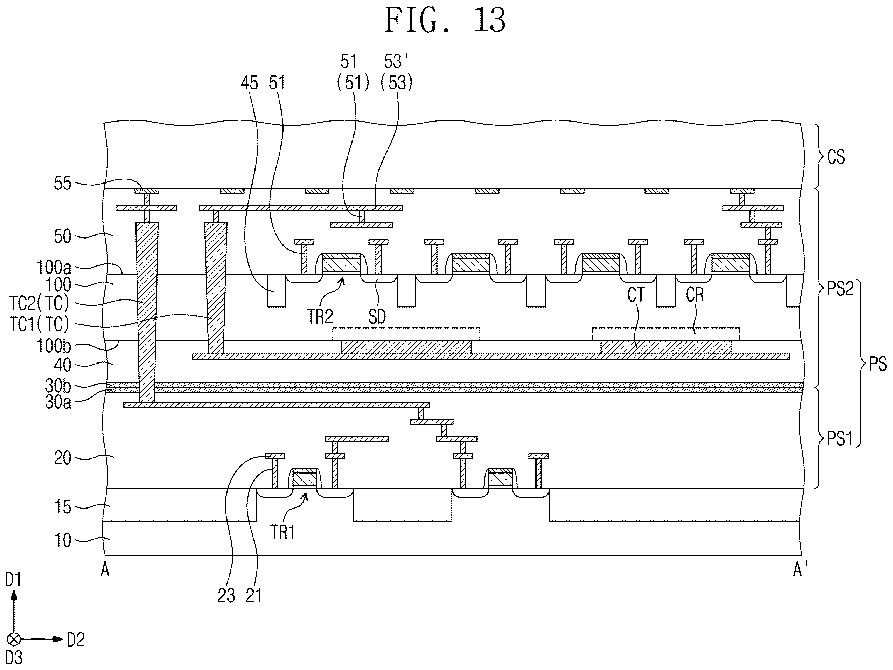

FIG. 12 is a plan view illustrating a three-dimensional semiconductor memory device according to some implementations of this disclosure. FIG. 13 is a cross-sectional view taken along line A-A' of FIG. 12.

Referring to FIGS. 12 and 13, a shape of the conductive contact CT may be variously modified by those of ordinary skill in the art without being limited to the above descriptions provided with reference to FIGS. 6 and 7.

For example, the conductive contact may have a shape of a bar. The conductive contact CT may extend in the second direction D2. The conductive contact CT may extend from a portion below one of a pair of the second transistors TR2 to a portion below the other one, but is not limited thereto. A range of extension of the conductive contact CT may be variously modified by those of ordinary skill in the art. Accordingly, operating characteristics of the plurality of second transistors TR2 may be controlled by providing the well bias voltage to the plurality of second transistors TR2 through a single conductive contact CT.

The contact region CR may extend in the second direction D2 according to the above-mentioned shape of the conductive contact CT.

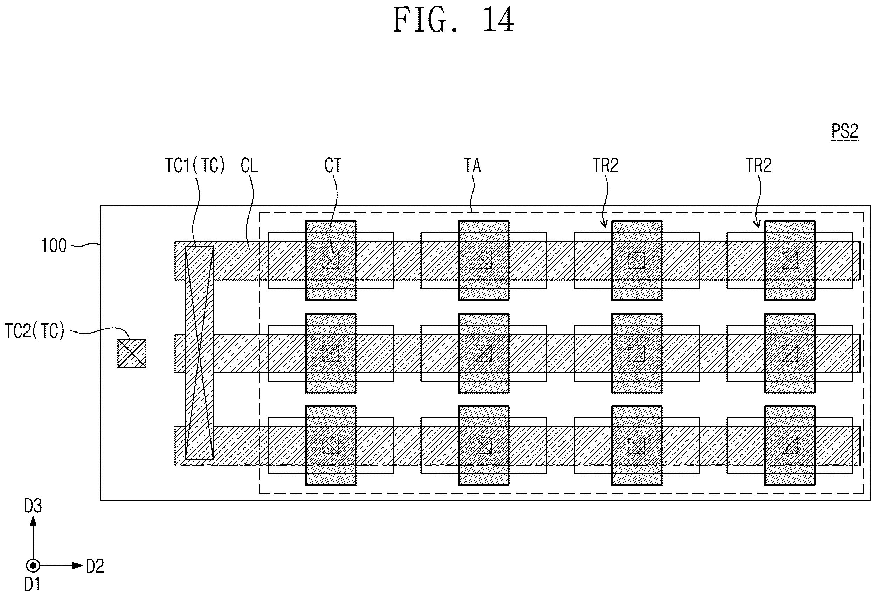

FIGS. 14 to 17 are plan views illustrating a three-dimensional semiconductor memory device according to some implementations of this disclosure.

Referring to FIG. 14, a shape of the first penetration pattern TC1 may be variously modified by those of ordinary skill in the art without being limited to the above descriptions provided with reference to FIGS. 6 and 7. For example, the first penetration pattern TC1 may have a shape of a bar extending in the first direction D1 and the third direction D3. Accordingly, a single first penetration pattern TC1 may be connected to the plurality of conductive lines CL.

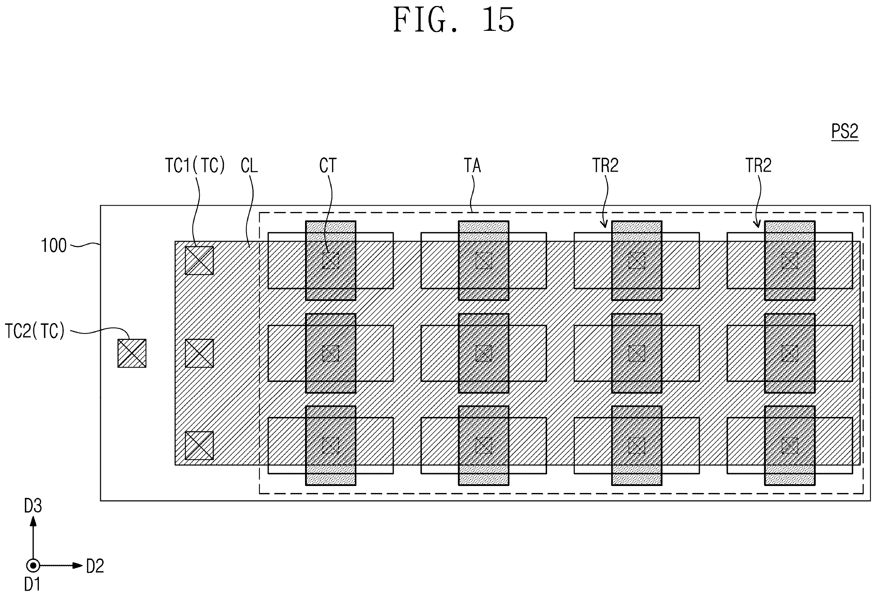

Referring to FIG. 15, a shape of the conductive line CL may be variously modified by those of ordinary skill in the art without being limited to the above descriptions provided with reference to FIGS. 6 and 7. For example, the conductive line CL may extend in the second direction D2 and the third direction D3. A width of the conductive line CL in the third direction D3 may be larger than that described with reference to FIGS. 6 and 7. Accordingly, a single conductive line CL may be connected to the conductive contacts CT arranged spaced apart from each other in the second direction D2 and the third direction D3. In addition, a single conductive line CL may be connected to the first penetration patterns TC1 arranged spaced apart from each other in the third direction D3.

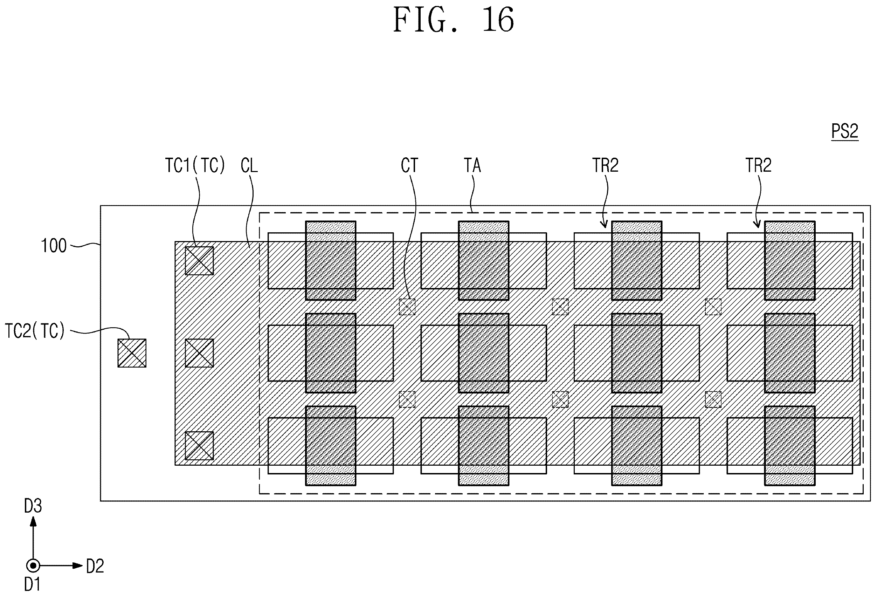

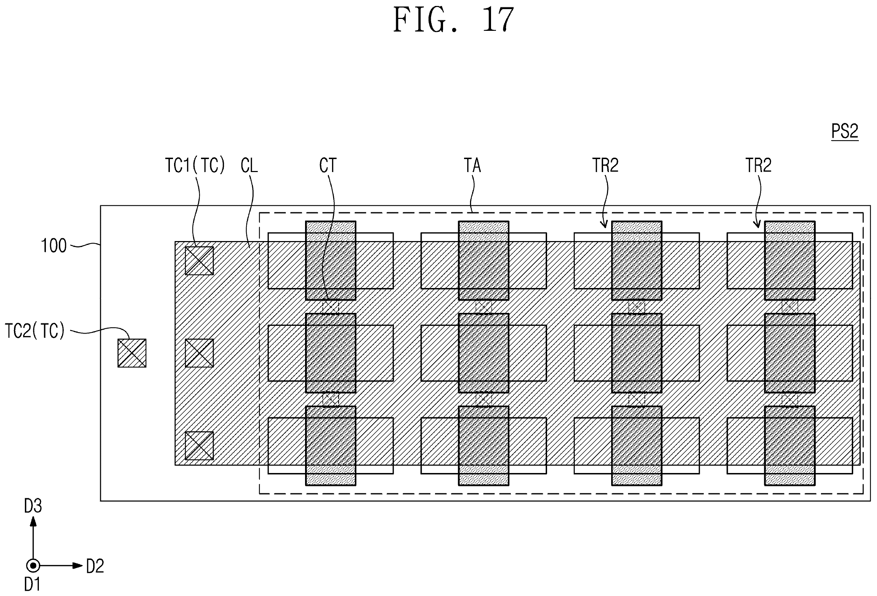

Referring to FIGS. 16 and 17, when the conductive line CL described above with reference to FIG. 15 is provided, a formation location of the conductive contact CT may be variously modified by those of ordinary skill in the art without being limited to the above descriptions provided with reference to FIGS. 6, 7, 10, and 11. Referring to FIG. 16, in a plan view, the conductive contact CT may be interposed at a center of four second transistors TR2 arranged spaced apart from each other clockwise. Referring to FIG. 17, the conductive contact CT may be interposed between the second transistors TR2 arranged spaced apart from each other in the third direction D3. Accordingly, operating characteristics of the plurality of second transistors TR2 may be controlled by providing the well bias voltage to the plurality of second transistors TR2 through a single conductive contact CT.

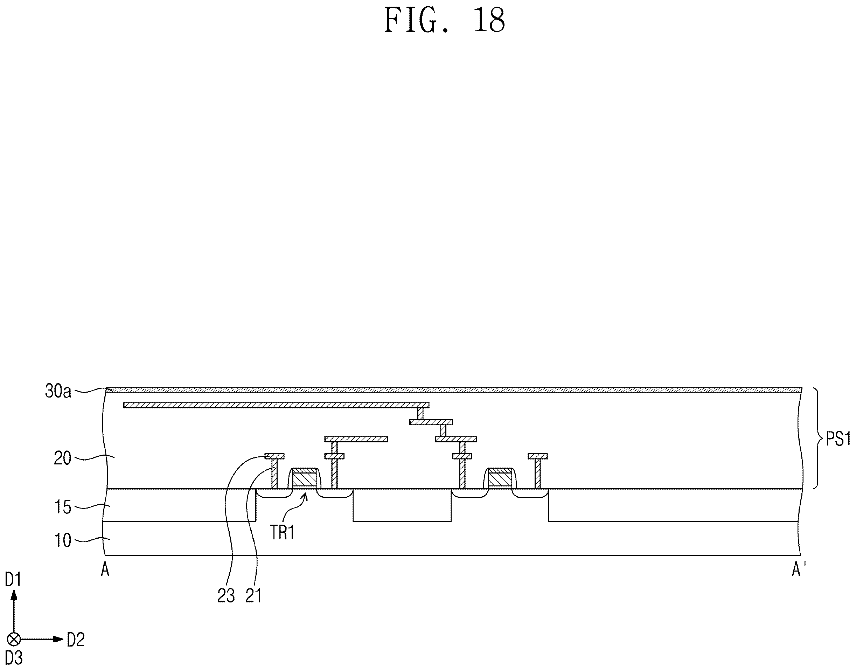

Hereinafter, a method for manufacturing a three-dimensional semiconductor memory device according to some implementations of this disclosure will be described with reference to FIGS. 18 to 21. For conciseness, descriptions overlapping with the above descriptions will be omitted, and differences will be mainly described.

FIGS. 18 to 21 are diagrams illustrating a method for manufacturing a three-dimensional semiconductor memory device according to some implementations of this disclosure. In detail, FIGS. 18 to 21 are cross-sectional views taken along line A-A' of FIG. 6.

Referring to FIG. 18, the first device isolation layer 15 may be formed in the first substrate 10. The first peripheral circuit structure PS1 may be formed on the first substrate 10. Forming the first peripheral circuit structure PS1 may include: forming the first transistors TR1 on an active region of the first substrate 10 defined by the first device isolation layer 15; and forming first contacts 21 and first circuit lines 23 electrically connected to the first transistors TR1, the first insulating layer 20 covering the foregoing, and the first bonding layer 30a on the first insulating layer 20.

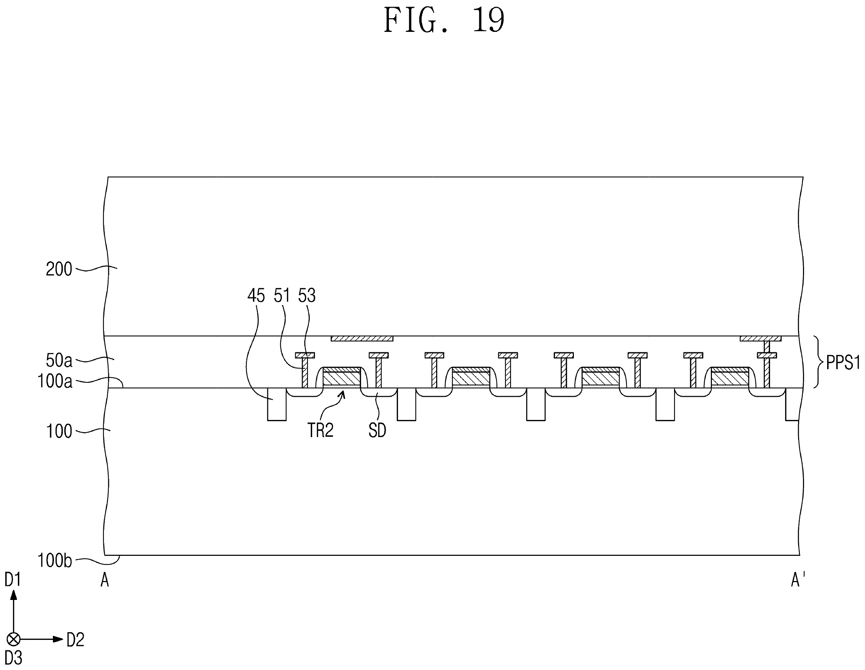

Referring to FIG. 19, the second device isolation layer 45 may be formed in the second substrate 100. A first circuit structure PPS1 may be formed on the second substrate 100. Forming the first circuit structure PPS1 may include: forming the second transistors TR2 on an active region of the second substrate 100 defined by the second device isolation layer 45; and forming second contacts 51 and second circuit lines 53 electrically connected to the second transistors TR2, and a first preliminary insulating layer 50a covering the foregoing.

For example, forming the source/drain regions SD of the second transistors TR2 may be performed by performing a first impurity injection process for injecting a first impurity into the first surface 100a of the second substrate 100. The first impurity may be injected into the second substrate 100 through the first impurity injection process.

A third substrate 200 may be formed on the first circuit structure PPS1. For example, the third substrate 200 may be a glass substrate or semiconductor substrate.

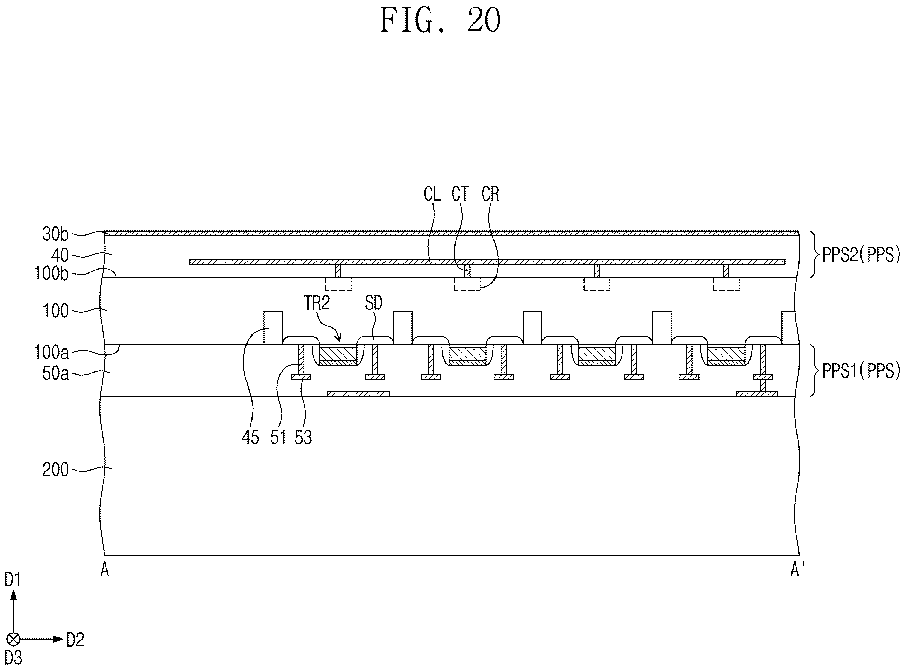

Referring FIG. 20, the second substrate 100 may be flipped so as to invert the first surface 100a and the second surface 100b of the second substrate 100 (i.e., the upper and lower surfaces of the second substrate 100). Thereafter, a portion of the second substrate 100 may be removed by performing a planarization process on the second surface 100b of the second substrate 100.

A second impurity injection process may be performed to inject a second impurity into the second surface 100b of the second substrate 100. Accordingly, the contact regions CR may be formed in the second substrate 100. For example, when performing the second impurity injection process, the second impurity may be injected into the second substrate 100 through a separate mask formed on the second surface 100b of the second substrate 100. Accordingly, the contact regions CR may be formed at a location where the contact regions CR described above with reference to FIGS. 7, 11, and 13 are provided. For another example, when performing the second impurity injection process, the second impurity may be injected into the second substrate 100 without a separate mask formed on the second surface 100b of the second substrate 100. Accordingly, the contact region CR may be formed at a location where the contact region CR described above with reference to FIG. 9 is provided.

For example, the first impurity and the second impurity may include different types of impurities.

A second circuit structure PPS2 may be formed on the second surface 100b of the second substrate 200. Forming the second circuit structure PPS2 may include forming the conductive contact CT on the second surface 100b of the second substrate 100, the conductive line CL on the conductive contact CT, the third insulating layer 40 covering the foregoing, and the second bonding layer 30b on the third insulating layer 40. The third insulating layer 40 may be formed at one time or over periods of time, and may be formed at various times regardless of whether the conductive contact CT and the conductive line CL have been formed or not.

The conductive contact CT may be formed at various locations and may have various shapes as described above regarding the formation locations and shapes of the conductive contact CT with reference to FIGS. 6, 10, 12, 16, and 17. The conductive line CL may be formed at various locations and may have various shapes as described above regarding the formation locations and shapes of the conductive line CL with reference to FIGS. 6, 14, and 15.

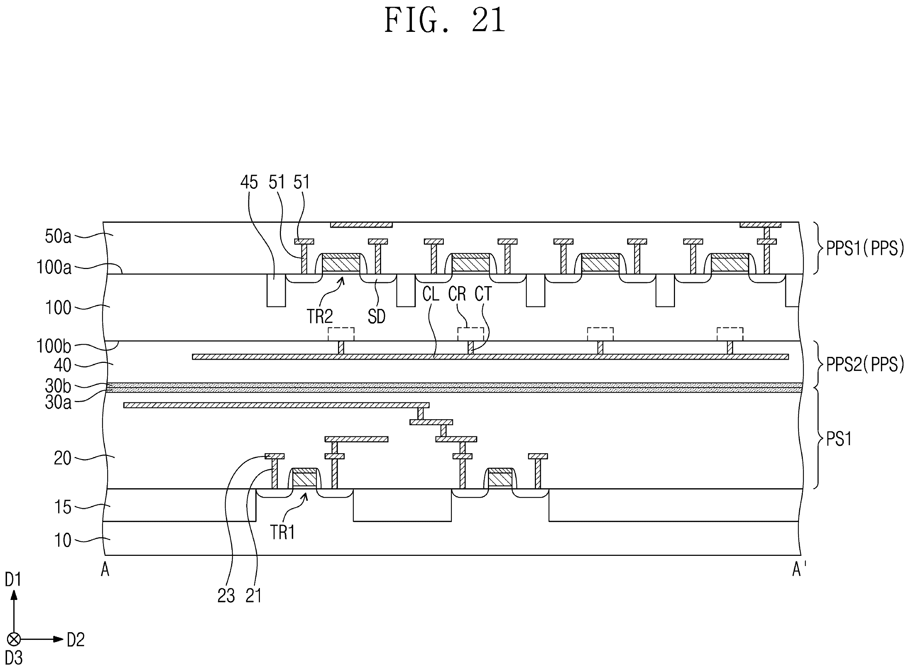

Referring to FIG. 21, a first bonding process may be performed to bond the second circuit structure PPS2 onto the first peripheral circuit structure PS1. Performing the first bonding process may include: flipping the second substrate 100 again so as to invert the first surface 100a and the second surface 100b of the second substrate 100 (i.e., the upper and lower surfaces of the second substrate 100) again; and bringing the second bonding layer 30b into contact with the first bonding layer 30a. Thereafter, the third substrate 200 (FIG. 20) may be removed.

Referring back to FIGS. 6, 7, and 8, the first penetration pattern TC1 may be formed so as to extend into the second substrate 100 and be connected to the conductive line CL. The second penetration pattern TC2 may extend into the second substrate 100 and extend into the first peripheral circuit structure PS1. The second penetration pattern TC2 may be connected to one of the first circuit lines 23.

Thereafter, a second preliminary insulating layer may be formed on the first preliminary insulating layer 50a (FIG. 21), and the first preliminary insulating layer 50a (FIG. 21) and the second preliminary insulating layer may constitute the second insulating layer 50 together. Additional second contacts 51 and second circuit lines 53 may be formed in the second insulating layer 50. The first bonding pads 55 may be formed at an upper portion of the second insulating layer 50. The first circuit structure PPS1 (FIG. 21) may further include the second insulating layer 50, additionally formed second contacts 51 and second circuit lines 53, and the first bonding pads 55. The first circuit structure PPS1 (FIG. 21), the second circuit structure PPS2 (FIG. 21), and the second substrate 100 may constitute the second peripheral circuit structure PS2 together.

Thereafter, a second bonding process may be performed to bond the cell array structure CS described above with reference to FIG. 8 onto the second peripheral circuit structure PS2 (i.e., the first circuit structure PPS1 (FIG. 21)). Performing the second bonding process may include bringing the first bonding pads 55 of the second peripheral circuit structure PS2 and the second bonding pads 65 of the cell array structure CS into contact with each other.

According to this disclosure, conductive contacts that deliver a well bias voltage to a transistor array may be provided on a second surface (e.g., rear surface) of a substrate. Since some components constituting a well bias circuit are provided on the second surface of the substrate, the integration density of the three-dimensional semiconductor memory device may be improved. Furthermore, the degree of freedom of design of lines provided on the second surface of the substrate may be improved.

As a comparative example, when the conductive contacts that deliver the well bias voltage are provided on a first surface (e.g., front surface) of the substrate and outside the transistor array, the distance between the conductive contacts and transistors at a center of the transistor array may increase. In this case, the electrical resistance between the conductive contacts and the transistors provided at the center of the transistor array may increase, and the electrical characteristics of the three-dimensional semiconductor memory device may deteriorate.

On the contrary, according to this disclosure, the conductive contacts that deliver the well bias voltage to the transistor array are provided on the second surface of the substrate, and thus may vertically overlap transistors. In other words, in a plan view, the conductive contacts may be provided in the transistor array. Accordingly, the distance between the conductive contacts and the transistors provided at the center of the transistor array may be smaller than the distance between the conductive contacts and the transistors provided at the center of the transistor array of the above-mentioned comparative example. As a result, the electrical resistance between the conductive contacts and the transistors provided at the center of the transistor array may decrease. Therefore, the electrical characteristics of the three-dimensional semiconductor memory device may be improved.

In addition, due to the above-mentioned features of this disclosure, the distance between the conductive contacts and the transistors provided at the center of the transistor array may be substantially the same as the distance between the conductive contacts and transistors provided at the periphery of the transistor array. Accordingly, a difference in the bias voltage delivered to the transistors in the transistor array may be reduced. As a result, dispersion of operating characteristics of the transistors controlled through the well bias voltage may be reduced. Therefore, the electrical characteristics of the three-dimensional semiconductor memory device may be improved.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Embodiments are set out in the following clauses:
Clause 1. A three-dimensional semiconductor memory device comprising a first peripheral circuit structure and a second peripheral circuit structure sequentially stacked on a first substrate, wherein the second peripheral circuit structure includes: a second substrate having a first surface and a second surface opposite the first surface; a transistor array including a plurality of transistors on the first surface of the second substrate; an insulating layer on the second surface of the second substrate; a conductive line extending in the insulating layer in a direction parallel to the first surface of the second substrate; and a conductive contact between the conductive line and the second surface of the second substrate.
Clause 2. The three-dimensional semiconductor memory device of Clause 1, wherein the conductive contact is in contact with the second surface of the second substrate.
Clause 3. The three-dimensional semiconductor memory device of Clause 1 or 2, wherein the second substrate includes a contact region provided at a lower portion of the second substrate, and the conductive contact is between the contact region and the conductive line.
Clause 4. The three-dimensional semiconductor memory device of Clause 3, wherein the conductive contact is in contact with the contact region.
Clause 5. The three-dimensional semiconductor memory device of Clause 3 or 4, wherein each transistor of the plurality of transistors includes source/drain regions provided at an upper portion of the second substrate, and the contact region includes an impurity of a conductive type different than the source/drain regions.
Clause 6. The three-dimensional semiconductor memory device of any preceding Clause 1, wherein the second peripheral circuit structure includes a first penetration pattern extending into the second substrate and connected to the conductive line and a second penetration pattern extending into the second substrate and the insulating layer and connected to the first peripheral circuit structure, wherein a height of the first penetration pattern is less than a height of the second penetration pattern.
Clause 7. The three-dimensional semiconductor memory device of any preceding Clause, wherein the conductive contact vertically overlaps the transistor array.
Clause 8. The three-dimensional semiconductor memory device of any preceding Clause, wherein the conductive contact includes, on the conductive line, a plurality of sub-contacts spaced apart from each other in the direction parallel to the first surface of the second substrate, and wherein each sub-contact of the plurality of sub-contacts vertically overlaps a corresponding transistor among the transistors.
Clause 9. The three-dimensional semiconductor memory device of any preceding Clause, wherein an upper surface of the conductive contact is located at a vertical level between the first surface of the second substrate and the second surface of the second substrate or at a vertical level that is the same as the second surface.
Clause 10. The three-dimensional semiconductor memory device of any preceding Clause, wherein the insulating layer is interposed between the second surface of the second substrate and the first peripheral circuit structure.
Clause 11. The three-dimensional semiconductor memory device of any preceding Clause, wherein the conductive contact extends to the second surface of the second substrate.
Clause 12. The three-dimensional semiconductor memory device of any preceding Clause, comprising a cell array structure on the second peripheral circuit structure, wherein the cell array structure includes: a stack structure including gate electrodes stacked in a direction perpendicular to the first surface of the second substrate, wherein the stack structure is on the second peripheral circuit structure; a semiconductor pattern extending into at least a portion of the stack structure and extending in the perpendicular direction; and a data storage pattern extending in the perpendicular direction between the stack structure and the semiconductor pattern.
Clause 13. A three-dimensional semiconductor memory device comprising a first peripheral circuit structure, a second peripheral circuit structure, and a cell array structure sequentially provided on a first substrate, wherein the second peripheral circuit structure includes: a second substrate; a transistor array including a plurality of transistors on the second substrate and between the second substrate and the cell array structure; an insulating layer between the second substrate and the first peripheral circuit structure; a conductive line extending in the insulating layer in a direction parallel to a first surface of the second substrate; and a conductive contact between the conductive line and the second substrate.
Clause 14. The three-dimensional semiconductor memory device of Clause 13, wherein the second substrate has a second surface that is on an opposite side of the second substrate to the first surface, the transistor array is on the first surface, and the conductive contact is on the second surface.
Clause 15. The three-dimensional semiconductor memory device of Clause 13 or 14, wherein the conductive contact is in contact with the second substrate.
Clause 16. The three-dimensional semiconductor memory device of Clause 13, 14 or 15, wherein the conductive contact includes a plurality of sub-contacts, the second substrate includes contact regions provided at a lower portion of the second substrate, each transistor of the plurality of transistors includes a source/drain region provided at an upper portion of the second substrate, and the contact regions include an impurity of a conductive type different than the source/drain regions.
Clause 17. The three-dimensional semiconductor memory device of Clause 16, wherein each sub-contact of the plurality of sub-contacts is in contact with a corresponding contact region among the contact regions.
Clause 18. The three-dimensional semiconductor memory device of any one of Clauses 13 to 17, wherein the conductive contact extends to a second surface of the second substrate that is on an opposite side of the second substrate to the first surface.
Clause 19. The three-dimensional semiconductor memory device of any one of Clauses 13 to 18, wherein the conductive contact vertically overlaps the transistor array.
Clause 20. An electronic system comprising: a three-dimensional semiconductor memory device; and a controller electrically connected to the three-dimensional semiconductor memory device through an input/output pad and configured to control the three-dimensional semiconductor memory device, wherein the three-dimensional semiconductor memory device comprises a first peripheral circuit structure and a second peripheral circuit structure sequentially stacked on a first substrate, wherein the second peripheral circuit structure includes a second substrate having a first surface and a second surface that is on side of the second substrate opposite to the first surface, a transistor array including a plurality of transistors on the first surface of the second substrate, an insulating layer on the second surface of the second substrate, a conductive line extending in the insulating layer in a direction parallel to the first surface of the second substrate, and a conductive contact between the conductive line and the second surface of the second substrate.

The above descriptions of implementations of this disclosure provide examples for describing this disclosure. Therefore, this disclosure is not limited to the above implementations, and it would be obvious that those skilled in the art could make various modifications and changes by combining the above implementations within the technical scope of this disclosure.

## Claims

1. A three-dimensional semiconductor memory device comprising:
a first peripheral circuit structure (PS1) and a second peripheral circuit structure (PS2) sequentially stacked on a first substrate (10),
wherein the second peripheral circuit structure (PS2) includes:
a second substrate (100) having a first surface (100a) and a second surface (100b) opposite the first surface (100a);
a transistor array (TA) including a plurality of transistors (TR2) on the first surface (100a) of the second substrate (100);
an insulating layer (40) on the second surface (100b) of the second substrate (100);
a conductive line (CL) extending in the insulating layer (40) in a direction parallel to the first surface (100a) of the second substrate (100); and
a conductive contact (CT) between the conductive line (CL) and the second surface (100b) of the second substrate (100).

2. The three-dimensional semiconductor memory device of claim 1, wherein the conductive contact (CT) is in contact with the second surface (100b) of the second substrate (100).

3. The three-dimensional semiconductor memory device of claim 1 or claim 2,
wherein the second substrate (100) includes a contact region (CR) provided at a lower portion of the second substrate (100), and
the conductive contact (CT) is between the contact region (CR) and the conductive line (CL).

4. The three-dimensional semiconductor memory device of claim 3, wherein the conductive contact (CT) is in contact with the contact region (CR).

5. The three-dimensional semiconductor memory device of claim 3 or 4,
wherein each transistor of the plurality of transistors (TR2) includes source/drain regions (SD) provided at an upper portion of the second substrate (100), and
the contact region (CR) includes an impurity of a conductive type different than the source/drain regions (SD).

6. The three-dimensional semiconductor memory device of any preceding claim,
wherein the second peripheral circuit structure (PS2) includes a first penetration pattern (TC1) extending into the second substrate (100) and connected to the conductive line (CL) and a second penetration pattern (TC2) extending into the second substrate (100) and the insulating layer (40) and connected to the first peripheral circuit structure (PS1),
wherein a height of the first penetration pattern (TC1) is less than a height of the second penetration pattern (TC2).

7. The three-dimensional semiconductor memory device of any preceding claim, wherein the conductive contact (CT) vertically overlaps the transistor array (TA).

8. The three-dimensional semiconductor memory device of any preceding claim,
wherein the conductive contact (CT) includes, on the conductive line (CL), a plurality of sub-contacts (CT) spaced apart from each other in the direction parallel to the first surface (100a) of the second substrate (100), and
wherein each sub-contact of the plurality of sub-contacts (CT) vertically overlaps a corresponding transistor among the transistors (TR2).

9. The three-dimensional semiconductor memory device of any preceding claim, wherein an upper surface of the conductive contact (CT) is located at a vertical level between the first surface (100a) of the second substrate (100) and the second surface (100b) of the second substrate (100) or at a vertical level that is the same as the second surface (100b).

10. The three-dimensional semiconductor memory device of any preceding claim, wherein the insulating layer (40) is interposed between the second surface (100b) of the second substrate (100) and the first peripheral circuit structure (PS1).

11. The three-dimensional semiconductor memory device of any preceding claim, wherein the conductive contact (CT) extends to the second surface (100b) of the second substrate (100).

12. The three-dimensional semiconductor memory device of any preceding claim, comprising a cell array structure (CS) on the second peripheral circuit structure (PS2),
wherein the cell array structure (CS) includes:
a stack structure (ST) including gate electrodes (GE1, GE2) stacked in a direction perpendicular to the first surface (100a) of the second substrate (100), wherein the stack structure (ST) is on the second peripheral circuit structure (PS2);
a semiconductor pattern (VSP) extending into at least a portion of the stack structure (ST) and extending in the perpendicular direction; and
a data storage pattern (DSP) extending in the perpendicular direction between the stack structure (ST) and the semiconductor pattern (VSP).
